# FASCICULE DE BREVET EUROPEEN

(11) **EP 3 400 503 B1**
(45) Date de publication et mention de la délivrance du brevet: **04.11.2020**
(21) Numéro de dépôt: 16834024.8
(22) Date de dépôt: 22.12.2016
(51) Int. Cl.: G06F 3/01, B60K 35/00, B60K 37/06, H03K 17/96

(54) **ORGANE DE COMMANDE**
STEUERELEMENT
CONTROL MEMBER

(30) Priorité: 07.01.2016 FR 1650098
(43) Date de publication de la demande: 14.11.2018
(73) Titulaire: PSA AUTOMOBILES S.A., 78300 Poissy (FR)
(72) Inventeur: CARVALHO, Jorge Filipe, 91420 Morangis (FR)
(74) Mandataire: Jeannin, Laurent Jean-Pierre
(86) Numéro de dépôt international: PCT/FR2016/053639
(87) Numéro de publication internationale: WO 2017/118790

(56) Documents cités:
- WO-A2-2013/173624
- US-A1- 2009 250 267
- US-A1- 2011 316 681
- US-A1- 2015 001 996

## Description

La présente invention concerne de manière générale un organe de commande, un dispositif de commande intégrant un tel organe de commande et un procédé de commande pour un appareil monté sur un véhicule automobile.

Il est connu dans l'art antérieur des organes ou dispositifs de commande, tel que celui divulgué dans le document US20110316681 qui décrit l'usage d'un polymère à mémoire de forme pour former des boutons ou interfaces de commande pouvant être intégrés à une planche de bord. En contrepartie, ce système présente notamment l'inconvénient d'être complexe en raison de la séquence de modification de la forme des interfaces de commande qui implique un unité de détection spécifique de commande, ainsi qu'en raison de l'architecture en protubérance intégrée à une molette ou un bouton mécanique. De plus, il n'y a pas de retour d'information sur la prise en compte de la commande ou non par le système.

On connait par le document US20090250267 un procédé et sur un appareil pour générer une texture de surface haptique avec une couche de surface déformable. Le dispositif haptique comprend une couche de surface flexible, un substrat haptique et un mécanisme de déformation. La couche de surface flexible est faite de matériaux élastiques et est capable de reconfigurer ses caractéristiques de surface. Le substrat haptique, dans un mode de réalisation, fournit un premier motif en réponse à un premier signal d'activation.

On connait aussi par le document WO2013173624 un procédé pour commander une interface utilisateur tactile dynamique consistant à détecter une valeur de capacitance sur une partie de cavité, une couche tactile définissant une région déformable et une région périphérique, ladite région périphérique étant adjacente à la région déformable, et ladite région déformable coopérant avec un substrat pour définir la cavité.

On connait aussi par le document US2015001996 un dispositif bistable reconfigurable comprenant un panneau élastiquement déformable latéralement disposée entre et reliée à un ou plusieurs éléments de montage reliés directement ou indirectement à des extrémités opposées du panneau.

On connait aussi par le document US2011316681 un dispositif haptique comprenant un élément de polymère à mémoire de forme.

Un but de la présente invention est de répondre aux inconvénients mentionnés ci-dessus et en particulier, tout d'abord, de proposer un organe de commande simple qui permet de fournir à l'utilisateur un retour d'information sur la prise en compte de la commande par le système.

Pour cela un premier aspect de l'invention concerne un organe de commande d'un appareil de véhicule, comprenant :
- une face externe agencée pour détecter depuis une position de repos une action de commande d'un utilisateur,
caractérisé :
- en ce que la face externe est agencée pour être mobile entre au moins une première position, occupée lorsque l'action de commande est détectée, et au moins une deuxième position, indicative que la commande est prise en compte,
- et en ce que l'organe de commande comprend au moins un élément avec un matériau à mémoire de forme agencé pour faire passer, lorsque l'action de commande est prise en compte, la face externe de la première position à la deuxième position. L'organe de commande est simplifié, puisque la face de commande sert à détecter l'action de commande, pour le fonctionnement d'un appareil du véhicule, mais aussi pour provoquer le passage de la première à la deuxième position. En d'autres termes, la face de commande sert à commander l'appareil du véhicule, mais aussi l'organe de commande lui-même. On a donc un déplacement de la face de commande initié en même temps ou peu après l'envoi de la commande de fonctionnement à l'appareil, mais dans tous les cas après avoir détecté l'action de commande de la part de l'utilisateur. Les éléments avec matériau à mémoire de forme servent à créer la force de mouvement de la face externe.

Dans le cas d'un organe de commande avec détection de proximité par capteur capacitif, la position de repos est confondue avec la première position. L'invention apporte un vrai plus, car normalement un tel capteur ne se déplace pas lorsqu'on le touche, et ici, l'utilisateur voit la face de commande se déplacer une fois la proximité détectée, ce qui lui indique que le système a bien détecté l'action de commande.

Dans le cas d'un organe de commande du type bouton poussoir, la position de repos est séparée de la première position et de la deuxième position : l'utilisateur enfonce le bouton poussoir de la position de repos vers la première position, et les éléments avec matériau à mémoire de forme font ensuite passer la face de commande vers la deuxième position, sans action de la part de l'utilisateur.

Autrement dit, l'invention concerne un organe de commande comprenant :
- une face externe agencée pour détecter une proximité avec un membre d'un utilisateur, tel qu'un doigt ou une main,
caractérisé :
- en ce que la face externe est agencée pour être mobile entre au moins une première position et au moins une deuxième position
- et en ce que l'organe de commande comprend au moins un élément avec un matériau à mémoire de forme agencé pour faire passer, lorsqu'une proximité avec un membre de l'utilisateur est détectée, la face externe de la première position à la deuxième position.

Avantageusement, la face externe peut former une figurine. De manière avantageuse, la figure peut être éclairée, ou rétro éclairée pour indiquer la fonction de la commande.

Avantageusement, la face externe est agencée pour détecter une proximité d'un membre de l'utilisateur.

Avantageusement, la face externe comprend au moins un capteur de détection sans contact, en particulier du type capacitif.

Avantageusement, la face externe forme une portion d'une surface d'un habitacle de véhicule automobile, telle qu'une portion d'une planche de bord. L'organe de commande est alors sans relief, ce qui allège le style du véhicule.

Avantageusement, le dit au moins un élément avec un matériau à mémoire de forme comprend au moins un élément métallique à mémoire de forme agencé pour faire passer la face externe de la première position à la deuxième position et/ou de la deuxième position à la première position sous l'action d'un courant électrique. Le courant électrique passe au travers de l'élément avec un matériau à mémoire de forme, afin de provoquer le changement de forme.

On peut envisager des alliages métalliques à mémoire de forme comprenant un alliage à base de nickel et/ou de titane. En particulier, on peut envisager d'utiliser des alliages Cuivre-Aluminium-Nickel, ou Cuivre-Aluminium-Zinc.

Selon l'invention, l'organe de commande comprend un socle fixe, et ledit au moins un élément avec un matériau à mémoire de forme est agencé entre le socle fixe et la face externe.

Avantageusement, le socle supporte au moins un circuit imprimé agencé pour commander ledit au moins un élément avec un matériau à mémoire de forme.

Un deuxième aspect de l'invention concerne un dispositif de commande comprenant :
- au moins un organe de commande selon le premier aspect de l'invention,
- des moyens de commande agencés pour recevoir de la part de la face externe une information de détection d'une action de commande de l'utilisateur et agencés pour commander au moins un appareil du véhicule en conséquence,
dans lequel les moyens de commande sont agencés pour commander ledit au moins un élément avec un matériau à mémoire de forme, suite à la réception de l'information de détection d'une action de commande de l'utilisateur.

Un troisième aspect de l'invention concerne un véhicule automobile comprenant au moins un organe de commande selon le premier aspect de l'invention, et/ou au moins un dispositif de commande selon le deuxième aspect de l'invention.

Un dernier aspect de l'invention concerne un procédé de commande d'un organe de commande selon le premier aspect de l'invention, comprenant les étapes consistant à :
- détecter une action de commande effectuée par un utilisateur,
- commander ledit au moins un élément avec un matériau à mémoire de forme, suite à la détection de l'action de commande effectuée par un utilisateur, pour faire passer la face externe de la première position, occupée par la face externe après la détection de l'action de commande, à la deuxième position, indicative que la commande est prise en compte.

D'autres caractéristiques et avantages de la présente invention apparaîtront plus clairement à la lecture de la description détaillée qui suit d'un mode de réalisation de l'invention donné à titre d'exemple nullement limitatif et illustré par les dessins annexés, dans lesquels :
- la figure 1 représente un organe de commande selon la présente invention, avant détection d'une action de commande effectuée par un utilisateur ;
- la figure 2 représente l'organe de commande de la figure 1, après détection d'une action de commande.

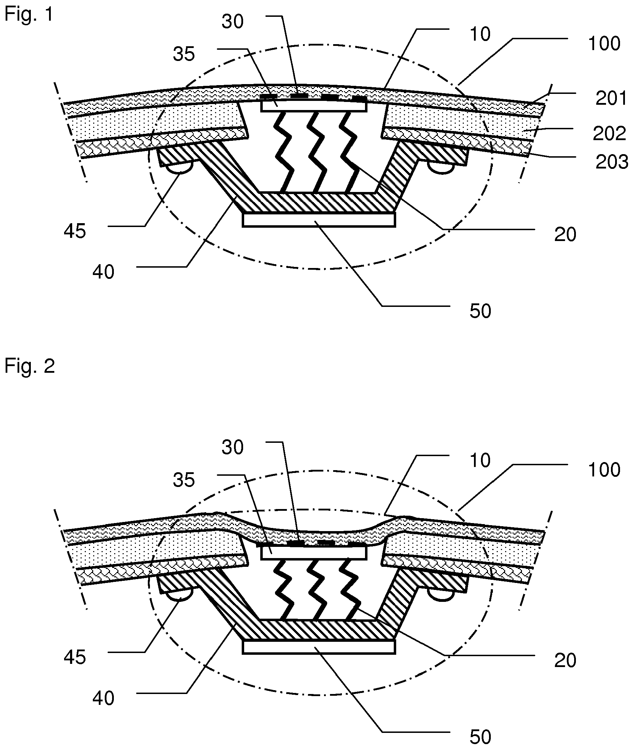

La figure 1 représente un organe de commande 100 qui comprend une face de commande 10, faisant partie d'une peau extérieure 201 d'une planche de bord par exemple.

La planche de bord est constituée d'un sandwich comprenant les couches 201, 202 et 203. La couche 203 forme une paroi interne de la planche de bord, sur laquelle on peut attacher un socle 40 (par deux bouterollages 45 par exemple).

Un système selon l'invention peut être illustré par trois éléments avec matériau à mémoire de forme 20 qui sont agencés entre le socle 40 et la face de commande 10. Plus précisément, les éléments avec matériau à mémoire de forme 20 sont solidaires d'un capteur capacitif 30 qui est agencé sous la peau extérieure 201, sur un support 35 fixé (par soudure ou collage) à la face interne de la peau extérieure 201, car un passage est ménagé dans les couches 202 et 203 de la planche de bord.

La face de commande 10 est donc agencée pour détecter sans contact la proximité avec un doigt d'un utilisateur, et quand ce dernier passe son doigt sur ou à proximité de la face de commande 10, celle-ci envoi un signal de détection à des moyens de commande placés sur un circuit imprimé 50, lui-même attaché au socle 40.

En conséquence, les moyens de commande peuvent commander à leur tour un appareil du véhicule (la climatisation, ou la radio par exemple). Cependant, les moyens de commande sont aussi agencés pour faire passer un courant électrique dans les éléments avec matériau à mémoire de forme 20, et ces derniers peuvent faire bouger la face de commande 10 pour l'enfoncer, comme représentée figure 2. Bien entendu, les éléments avec matériau à mémoire de forme 20 peuvent provoquer un mouvement opposé, pour faire apparaître une protubérance sur la planche de bord à la place d'un creux, suivant le type d'utilisation fonctionnel (comme un push ou bouton poussoir instable, après acquisition la surface revient dans sa forme initiale.)

En d'autres termes, on profite de l'élasticité de la peau extérieure 201 pour implanter l'organe de commande 100 et procurer un organe de commande initialement sans relief, mais qui procure à l'utilisateur un retour d'information que la commande est bien prise en compte, puisqu'en parallèle de la commande de l'appareil du véhicule, l'organe de commande 100 se déforme pour présente un aspect visuel différent au moment de la détection de l'action de commande.

Pour la désactivation de la mise en forme, on peut prévoir soit des éléments avec matériau à mémoire de forme 20 opposés (c'est-à-dire avec la position mémoire qui est la position de la figure 1), ou de refaire passer un courant électrique dans les éléments avec matériau à mémoire de forme 20 déjà activés pour les refaire passer dans la position de la figure 1.

Dans le cas où la face de commande 10 comprend un capteur capacitif 30, l'invention procure une mobilité de la face de commande 10 qui offre un retour d'information appréciable pour l'utilisateur, car ce dernier a la confirmation, une fois après avoir passé son doigt à proximité, que le système a bien pris en compte la commande.

On comprendra que diverses modifications et/ou améliorations évidentes pour l'homme du métier peuvent être apportées aux différents modes de réalisation de l'invention décrits dans la présente description sans sortir du cadre de l'invention défini par les revendications annexées. En particulier, il est fait mention d'une intégration dans une planche de bord, mais on peut envisager d'implanter la face externe de l'organe de commande dans un volant ou une console centrale.

## Revendications

1. Organe de commande (100) d'un appareil de véhicule, comprenant :
- une face externe (10) agencée pour détecter depuis une position de repos une action de commande d'un utilisateur,
- la face externe (10) étant agencée pour être mobile entre au moins une première position, occupée lorsque l'action de commande est détectée, et au moins une deuxième position, indicative que la commande est prise en compte,
- l'organe de commande (100) comprenant au moins un élément avec un matériau à mémoire de forme (20) agencé pour faire passer, lorsque l'action de commande est prise en compte, la face externe (10) de la première position à la deuxième position,
**caractérisé en ce qu'**il comprend un socle fixe (40), ledit au moins un élément avec un matériau à mémoire de forme (20) étant agencé entre le socle fixe (40) et la face externe (10).

2. Organe de commande (100) selon la revendication précédente, dans lequel la face externe (10) est agencée pour détecter une proximité d'un membre de l'utilisateur.

3. Organe de commande (100) selon l'une des revendications précédentes, dans lequel la face externe (10) comprend au moins un capteur de détection sans contact (30), en particulier du type capacitif.

4. Organe de commande (100) selon l'une des revendications précédentes, dans lequel la face externe (10) forme une portion d'une surface d'un habitacle de véhicule automobile, telle qu'une portion d'une planche de bord.

5. Organe de commande (100) selon l'une des revendications précédentes, dans lequel le dit au moins un élément avec un matériau à mémoire de forme (20) comprend au moins un élément métallique à mémoire de forme agencé pour faire passer la face externe (10) de la première position à la deuxième position et/ou de la deuxième position à la première position sous l'action d'un courant électrique.

6. Organe de commande (100) selon la revendication précédente, dans lequel le socle supporte au moins un circuit imprimé (50) agencé pour commander ledit au moins un élément avec un matériau à mémoire de forme (20).

7. Dispositif de commande comprenant :
- au moins un organe de commande (100) selon l'une des revendications précédentes,
- des moyens de commande agencés pour recevoir de la part de la face externe (10) une information de détection d'une action de commande de l'utilisateur et agencés pour commander au moins un appareil du véhicule en conséquence,
dans lequel les moyens de commande sont agencés pour commander ledit au moins un élément avec un matériau à mémoire de forme (20), suite à la réception de l'information de détection d'une action de commande de l'utilisateur.

8. Véhicule automobile comprenant au moins un organe de commande (100) selon l'une des revendications 1 à 6, et/ou au moins un dispositif de commande selon la revendication précédente.

9. Procédé de commande d'un organe de commande (100) selon l'une des revendications 1 à 6, comprenant les étapes consistant à :
- détecter une action de commande effectuée par un utilisateur,
- commander ledit au moins un élément avec un matériau à mémoire de forme (20), suite à la détection de l'action de commande effectuée par un utilisateur, pour faire passer la face externe (10) de la première position, occupée par la face externe (10) après la détection de l'action de commande, à la deuxième position, indicative que la commande est prise en compte.

## Patentansprüche

1. Ein Stellglied (100) für eine Fahrzeugvorrichtung, umfassend :
- ein äußeres Gesicht (10), das so angeordnet ist, dass es aus einer Ruheposition heraus eine Kontrollaktion eines Benutzers erkennt,
- wobei die Außenfläche (10) so angeordnet ist, dass sie zwischen mindestens einer ersten Position, die eingenommen wird, wenn der Steuerungsvorgang erfasst wird, und mindestens einer zweiten Position, die anzeigt, dass die Steuerung berücksichtigt wird, beweglich ist,
- wobei das Steuerelement (100) mindestens ein Element mit einem Formgedächtnismaterial (20) umfasst, das so angeordnet ist, dass es, wenn die Steuerwirkung berücksichtigt wird, die Außenfläche (10) von der ersten Position in die zweite Position bewegt,
**dadurch gekennzeichnet, dass** es eine feste Basis (40) umfasst, wobei das mindestens eine Element mit einem Formgedächtnismaterial (20) zwischen der festen Basis (40) und der Außenfläche (10) angeordnet ist.

2. Aktuator (100) nach dem vorhergehenden Anspruch, wobei die Außenfläche (10) so angeordnet ist, dass sie die Nähe der Gliedmaße eines Benutzers erkennt.

3. Aktuator (100) nach einem der vorstehenden Ansprüche, wobei die Außenfläche (10) mindestens einen berührungslosen Erfassungssensor (30), insbesondere vom kapazitiven Typ, aufweist.

4. Stellglied (100) nach einem der vorstehenden Ansprüche, wobei die Außenfläche (10) einen Teil einer Oberfläche eines Fahrgastraums eines Kraftfahrzeugs, wie beispielsweise einen Teil eines Armaturenbretts, bildet.

5. Steuergerät (100) nach einem der vorstehenden Ansprüche, wobei das mindestens eine Element mit einem Formgedächtnismaterial (20) mindestens ein metallisches Formgedächtniselement umfasst, das so angeordnet ist, dass es die Außenfläche (10) unter der Einwirkung eines elektrischen Stroms von der ersten Position in die zweite Position und/oder von der zweiten Position in die erste Position bewegt.

6. Steuergerät (100) nach dem vorhergehenden Anspruch, wobei die Basis mindestens eine gedruckte Schaltung (50) trägt, die so angeordnet ist, dass sie das mindestens eine Element mit einem Formgedächtnismaterial (20) steuert.

7. Ein Controller mit :
- mindestens ein Kontrolleur (100) gemäß einem der vorstehenden Ansprüche,
- Steuermittel, die so angeordnet sind, dass sie von der Außenfläche (10) Informationen zum Erkennen einer Steueraktion des Benutzers empfangen, und die so angeordnet sind, dass sie mindestens ein Gerät des Fahrzeugs entsprechend steuern,
wobei die Steuereinrichtung angeordnet ist, um das mindestens eine Element mit einem Formgedächtnismaterial (20) bei Empfang der Information zum Erfassen einer Steueraktion des Benutzers zu steuern.

8. Kraftfahrzeug mit mindestens einem Steuermittel (100) nach einem der Ansprüche 1 bis 6 und/oder mindestens einer Steuervorrichtung nach dem vorhergehenden Anspruch.

9. Verfahren zum Steuern eines Steuerelements (100) nach einem der Ansprüche 1 bis 6, umfassend die Schritte :
- Erkennung einer von einem Benutzer ausgeführten Steueraktion,
- Steuern des mindestens einen Elements mit einem Formgedächtnismaterial (20) nach der Erfassung der von einem Benutzer ausgeführten Steueraktion, um die Außenfläche (10) von der ersten Position, die von der Außenfläche (10) nach der Erfassung der Steueraktion eingenommen wird, in die zweite Position zu bewegen, die anzeigt, dass die Steuerung berücksichtigt wird.

## Claims

1. Control unit (100) for a vehicle apparatus, comprising :
- an external face (10) arranged to detect from a rest position a control action of a user,
- the outer face (10) being arranged to be movable between at least one first position, occupied when the control action is detected, and at least one second position, indicating that the control action is taken into account,
- the control member (100) comprising at least one element with a shape memory material (20) arranged to move, when the control action is taken into account, the outer face (10) from the first position to the second position,
**characterised in that** it comprises a fixed base (40), said at least one element with a shape memory material (20) being arranged between the fixed base (40) and the outer face (10).

2. An actuator (100) according to the preceding claim, wherein the outer face (10) is arranged to detect a proximity of a user's limb.

3. Actuator (100) according to one of the preceding claims, wherein the outer face (10) comprises at least one non-contact detection sensor (30), in particular of the capacitive type.

4. An actuator (100) according to one of the preceding claims, wherein the outer face (10) forms a portion of a surface of a motor vehicle passenger compartment, such as a portion of a dashboard.

5. A control member (100) according to one of the preceding claims, wherein said at least one element with a shape memory material (20) comprises at least one metallic shape memory element arranged to move the outer face (10) from the first position to the second position and/or from the second position to the first position under the action of an electric current.

6. A controller (100) according to the preceding claim, wherein the base supports at least one printed circuit (50) arranged to control said at least one element with a shape memory material (20).

7. Control device comprising :
- at least one actuator (100) according to one of the preceding claims,
- control means arranged to receive from the external face (10) information for detecting a control action by the user and arranged to control at least one vehicle device accordingly,
wherein the control means are arranged to control said at least one element with a shape memory material (20), following receipt of information for detecting a control action by the user.

8. A motor vehicle comprising at least one control means (100) according to one of claims 1 to 6, and/or at least one control device according to the preceding claim.

9. A method for controlling a control device (100) according to one of claims 1 to 6, comprising the steps of :
- detecting a control action performed by a user,
- controlling said at least one element with a shape memory material (20), following the detection of the control action performed by a user, to move the external face (10) from the first position, occupied by the external face (10) after the detection of the control action, to the second position, indicative that the control is taken into account.
